# EUROPÄISCHE PATENTSCHRIFT

(11) **EP 3 200 573 B1**
(45) Veröffentlichungstag und Bekanntmachung des Hinweises auf die Patenterteilung: **02.12.2020**
(21) Anmeldenummer: 17153273.2
(22) Anmeldetag: 26.01.2017
(51) Int. Cl.: H05K 7/14

(54) **ELEKTRONIKGERÄT**
ELECTRONIC DEVICE
DISPOSITIF ÉLECTRONIQUE

(30) Priorität: 27.01.2016 DE 102016101409
(43) Veröffentlichungstag der Anmeldung: 02.08.2017
(73) Patentinhaber: Phoenix Contact GmbH & Co. KG, 32825 Blomberg (DE)
(72) Erfinder: GIEFERS, Stefan, 32805 Horn Bad Meinberg (DE)

(56) Entgegenhaltungen:
- EP-A1- 1 153 534
- DE-B3-102012 103 217
- Anonymous: "RasPiBox Open - Duinocade, Raspibox, Mini Arcade, EUzebox", , 1. August 2015 (2015-08-01), XP055381376, Gefunden im Internet: URL:https://web.archive.org/web/2015080109 3112/http://www.hwhardsoft.de/deutsch/proj ekte/rasppibox-open/ [gefunden am 2017-06-14]

## Beschreibung

Die Erfindung betrifft ein Elektronikgerät mit einem an eine Tragschiene ansetzbaren Gehäuse nach dem Oberbegriff des Anspruchs 1.

Ein derartiges Gehäuse umfasst ein Gehäuseoberteil, das zwei längs entlang einer Längsrichtung erstreckte, entlang einer Querrichtung quer zur Längsrichtung zueinander beabstandete Seitenwandungen und eine zwischen den Seitenwandungen gebildete Aufnahmekammer zur Aufnahme einer Elektronikbaugruppe aufweist. Zumindest eine der Seitenwandungen weist eine erste Öffnung auf, über die eine erste elektrische Leitung an einen ersten Anschluss der Elektronikbaugruppe anschließbar ist.

Bei einer solchen Elektronikbaugruppe handelt es sich beispielsweise um eine Platine mit einem oder mehreren daran angeschlossenen elektronischen Bauteilen, beispielsweise elektronischen Chips. Eine solche Elektronikbaugruppe kann beispielsweise einen Einplatinencomputer, beispielsweise erhältlich unter der Bezeichnung Raspberry Pi, handeln. Ein solcher Einplatinencomputer, Englisch bezeichnet als Single Board Computer (kurz SBC) stellt ein Computersystem dar, bei dem alle wesentlichen zum Betrieb eines Computersystems notwendigen elektronischen Komponenten auf einer einzigen Leiterplatte zusammengefasst sind, wobei typischerweise das Netzteil als einzige Komponente separat zu der Leiterplatte ausgebildet ist. Solcher Einplatinencomputer werden beispielsweise durch private Anwender für Hobbyanwendungen oder auch durch gewerbliche Anwender beispielsweise für Steuerungs-, Meß-, Regel- und Überwachungsfunktionen in Industrie und Forschung eingesetzt.

Mittels eines an eine Tragschiene ansetzbaren Gehäuses kann eine Elektronikbaugruppe mit einer Tragschiene verbunden und zusammen mit anderen Bauteilen, beispielsweise anderen Elektronikgeräten oder dergleichen, zu einer elektrischen Anlage kombiniert werden, die Steuerungs-, Meß-, Regel- oder Überwachungsfunktionen übernehmen kann.

Bei solchen Gehäusen ist es wünschenswert, dass sie kompatibel sind zu üblichen Schaltschrankmaßen, wie sie beispielsweise durch die DIN EN 43880 (letzte Ausgabe 1988-12) vorgegeben sind. Hierbei ergibt sich die Schwierigkeit, dass Elektronikbaugruppen beispielsweise in Form von Einplatinencomputer häufig Anschlüsse an unterschiedlichen Kanten einer Platine aufweisen, sodass elektrische Leitungen von unterschiedlichen Richtungen an unterschiedliche Kanten der Platine anzusetzen sind, was erfordert, dass die Elektronikbaugruppe von unterschiedlichen Seiten zugänglich ist. Dennoch soll das die Elektronikbaugruppe aufnehmende Gehäuse jedoch mit anderen Gehäusen kombinierbar und hierzu lückenlos an andere Gehäuse anreihbar bleiben.

Bei einem aus der DE 10 2009 044 901 A1 bekannten Gehäuse ist eine Elektronikbaugruppe in einer Aufnahmekammer aufgenommen. Das Gehäuse weist einen Deckel auf, um einen Zugang zu der in dem Gehäuse angeordneten Elektronikbaugruppe zu schaffen.

Ein aus der DE 20 2006 006 615 U1 bekanntes Gehäuse ist dazu ausgestaltet, mehrere Leiterplatten aufzunehmen.

Aus der DE 44 34 064 A1 ist ein Gehäuse bekannt, in dem eine Leiterplatte über einen Leiterplattenhalter befestigt werden kann.

Des Weiteren sind Gehäuse der betreffenden Art bekannt aus EP 1 153 534 A1 wie auch DE 10 2012 103217 B3 bekannt.

Ferner betrifft die Internetveröffentlichung mit dem Titel "RasPiBox Open - Duinocade, Raspibox, Mini Arcade, EUzebox" (datiert 01.08.2018, XP055381376, URL (14.06.2017): https://web.archive.org/web/20150801093112/http://www.hwhardsoft.de/deutsch/projekte/ rasppibox-open/) gattungsgemäße Gehäuse.

Aufgabe der vorliegenden Erfindung ist es, ein Elektronikgerät mit einem an eine Tragschiene ansetzbaren Gehäuse bereitzustellen, das ein flexibles Anschließen von elektrischen Leitungen an eine Elektronikbaugruppe ermöglicht und zudem mit anderen Gehäusen an einer Tragschiene kombinierbar ist.

Diese Aufgabe wird durch einen Gegenstand mit den Merkmalen des Anspruchs 1 gelöst.

Demnach weist das Gehäuseoberteil des Gehäuses eines erfindungsmäßen Elektronikgeräts eine entlang der Längsrichtung zu der Aufnahmekammer versetzte, zwischen den Seitenwandungen gebildete Anschlusskammer auf, die derart hin zu der Aufnahmekammer geöffnet ist, dass über die Anschlusskammer eine zweite elektrische Leitung an einen zweiten elektrischen Anschluss der Elektronikbaugruppe anschließbar ist.

Das Gehäuse ist demnach funktional zweigeteilt, indem an dem Gehäuseoberteil zum einen eine Aufnahmekammer zur Aufnahme der Elektronikbaugruppe und zum anderen eine Anschlusskammer zum Anschließen von einer oder mehreren elektrischen Leitungen an Anschlüsse der Elektronikbaugruppe gebildet ist. In die Aufnahmekammer kann die Elektronikbaugruppe eingesetzt werden, und in montiertem Zustand ist die Elektronikbaugruppe in der Aufnahmekammer eingefasst. Elektrische Leitungen können hierbei zum einen über eine oder beide der Seitenwandungen und darin gebildete Öffnungen an (erste) Anschlüsse der Elektronikbaugruppe angeschlossen werden. Zudem können weitere elektrische Leitungen über die Anschlusskammer an weitere (zweite) elektrische Anschlüsse der Elektronikbaugruppe angeschlossen werden, sodass Anschlüsse an unterschiedlichen Seiten der Elektronikbaugruppe in flexibler Weise zugänglich sind und ein Anschließen unterschiedlicher Leitungen ermöglichen.

Die Längsrichtung, entlang derer die Aufnahmekammer und die Anschlusskammer zueinander versetzt sind, kann beispielsweise der Längserstreckungsrichtung der Tragschiene entsprechen. Entlang der Längsrichtung zueinander versetzt können unterschiedliche Gehäuse von unterschiedlichen Elektronikgeräten aneinander angereiht und an die Tragschiene angesetzt werden, sodass auf diese Weise eine elektrische Anlage geschaffen wird, die beispielsweise Steuerungs-, Meß-, Regel- oder Überwachungsfunktionen in einer Industrieanlage oder dergleichen übernehmen kann.

Die Seitenwandungen erstrecken sich hierbei in parallelen, durch die Längsrichtung und eine Vertikalrichtung senkrecht zur Längsrichtung und senkrecht zur Querrichtung aufgespannten Ebenen, sodass über die (ersten) Öffnungen in den Seitenwandungen elektrische Leitungen ohne weiteres hin zu dem Gehäuse verlegt werden können. Weil entlang der Längsrichtung unterschiedliche Gehäuse aneinander anreihbar sein sollen, können jedoch entlang der Längsrichtung elektrische Leitungen nicht ohne weiteres hin zu der Elektronikbaugruppe geführt werden. Hierzu ist die Anschlusskammer vorgesehen, die zu der Aufnahmekammer entlang der Längsrichtung versetzt ist und somit einen Zugang zu der Aufnahmekammer entlang der Längsrichtung schafft. Über die Anschlusskammer kann eine elektrische Leitung an einen der Anschlusskammer zugewandten Anschluss der Elektronikbaugruppe angeschlossen werden, wobei elektrische Leitungen über die Aufnahmekammer weg von dem Gehäuse geführt werden können, sodass die elektrischen Leitungen ein Anreihen unterschiedlicher Gehäuse entlang der Längsrichtung an einer Tragschiene nicht verhindern.

Die Anschlusskammer ist an zumindest einer der Seitenwandungen nach außen hin geöffnet. Hierzu weist zumindest eine der Seitenwandungen eine zweite Öffnung auf, über die eine (zweite) elektrische Leitung in die Anschlusskammer einführbar ist, sodass die (zweite) elektrische Leitung innerhalb der Anschlusskammer an den (zweiten) Anschluss der Elektronikbaugruppe angeschlossen werden kann.

Durch das Vorsehen der Aufnahmekammer zur Aufnahme der Elektronikbaugruppe und der Anschlusskammer zum Schaffen von Raum zum Anschließen einer elektrischen Leitung an die Elektronikbaugruppe innerhalb des Gehäuses ist das Gehäuse funktional zweigeteilt. Hierbei ist die Anschlusskammer auch strukturell von der Aufnahmekammer getrennt, indem erfindungsgemäß eine quer zur Längsrichtung erstreckte Trennwand zwischen der Anschlusskammer und der Aufnahmekammer vorgesehen ist. Um ein Anschließen einer elektrischen Leitung an einen Anschluss der Elektronikbaugruppe von Seiten der Anschlusskammer zu ermöglichen, weist die Trennwand eine Öffnung auf, über die die zweite elektrische Leitung beispielsweise mit einem geeigneten Steckverbinder in Eingriff mit dem zugeordneten Anschluss auf Seiten der Elektronikbaugruppe gebracht werden kann.

Das Gehäuse kann beispielsweise ein Gehäuseoberteil und zusätzlich ein mit dem Gehäuseoberteil zusammenfügbares Gehäuseunterteil aufweisen, die gemeinsam die Aufnahmekammer und die Anschlusskammer einfassen. Während das Gehäuseoberteil - bei an eine Tragschiene angesetztem Gehäuse - an einer von der Tragschiene abgewandten Seite des Gehäuses angeordnet ist, kann das Gehäuseunterteil beispielsweise eine Befestigungseinrichtung aufweisen, über die das Gehäuse an der Tragschiene festgelegt werden kann. Die Tragschiene kann beispielsweise als Hutschiene (mit einer im Querschnitt hutähnlichen Form) aufweisen. Die Befestigungseinrichtung des Gehäuseunterteils kann in diesem Fall beispielsweise die Gestalt einer Aussparung mit daran angeordneten Verriegelungselementen, über die das Gehäuseunterteil mit der Tragschiene verrastet werden kann, aufweisen.

In einem Ausgangszustand können das Gehäuseoberteil und das Gehäuseunterteil getrennt voneinander vorliegen, sodass die Elektronikbaugruppe an das Gehäuseoberteil angesetzt und durch Zusammenfügen des Gehäuseoberteils mit dem Gehäuseunterteil in dem Gehäuse eingefasst werden kann. Das Gehäuseoberteil und das Gehäuseunterteil können hierbei beispielsweise formschlüssig durch geeignete Rastelemente oder dergleichen miteinander zu verbinden sein. Alternativ ist auch denkbar und möglich, das Gehäuseoberteil beispielsweise mit dem Gehäuseunterteil zu verschrauben.

An einer von dem Gehäuseunterteil abgewandten Seite kann das Gehäuseoberteil beispielsweise eine Deckenwandung aufweisen, an der ein bewegbarer Deckel angeordnet ist. Der Deckel kann beispielsweise geöffnet werden, um einen Zugriff auf die Aufnahmekammer und/oder die Anschlusskammer zu schaffen. Durch Öffnen des Deckels kann somit beispielsweise auf eine Elektronikbaugruppe innerhalb der Aufnahmekammer zugegriffen werden, wobei zum Beispiel auch denkbar und möglich ist, durch Öffnen des Deckels und eine dadurch freigegebene Öffnung in dem Gehäuse elektrische Leitungen von oben an die Elektronikbaugruppe anzuschließen.

Erfindungsgemäß weist das Gehäuseoberteil zwei quer zur Längsrichtung erstreckte Stirnwandungen auf, die entlang der Längsrichtung zueinander beabstandet sind und Endflächen des Gehäuses ausbilden. Das Gehäuse wird somit - betrachtet entlang der Längsrichtung - beidseitig durch die Stirnwandungen begrenzt, sodass ein flächiger Abschluss für das Gehäuse geschaffen wird, der ein Kombinieren des Gehäuses mit anderen Elektronikgeräten und ein aneinandergereihtes Ansetzen an eine Tragschiene ermöglicht. Über die Stirnwandungen kann das Gehäuse somit lückenlos mit weiteren Einrichtungen kombiniert werden, sodass eine aneinandergereihte Formation von Elektronikgeräten, Klemmenelementen oder dergleichen an einer Tragschiene geschaffen werden kann.

Die Abmessungen des Gehäuses, insbesondere gemessen entlang der Längsrichtung, können den Vorgaben nach DIN EN 43880 entsprechen, sodass das Gehäuse flexibel mit anderen Komponenten nach DIN EN 43880 kombinierbar ist und insbesondere das durch die DIN EN 43880 vorgegebene Breitenraster erfüllt.

Ein Elektronikgerät umfasst ein Gehäuse der vorangehend beschriebenen Art und zudem eine in der Aufnahmekammer des Gehäuses aufgenommene Elektronikbaugruppe, die beispielsweise als Einplatinencomputer ausgebildet sein kann. Bei einem solchen Einplatinencomputer sind die wesentlichen für einen Betrieb eines Computersystems erforderlichen elektronischen Komponenten auf einer einzigen Leiterplatte vereint, sodass ein Computersystem auf einer einzigen Platine geschaffen wird. Durch ein solches Einplatinencomputersystem können beispielsweise Steuerungs- und Automatisierungsfunktionen in einer Industrieanlage oder dergleichen übernommen werden.

Die Elektronikbaugruppe weist erfindungsgemäß eine Platine (auch bezeichnet als Leiterplatte) mit einem darauf angeordneten elektronischen Bauteil, beispielsweise einem elektronischen Chip, auf. Die Platine hat erfindungsgemäß an unterschiedlichen Kanten unterschiedliche Anschlüsse, beispielsweise einen Netzwerkanschluss (RJ45 oder dergleichen), einen USB-Anschluss, einen HDMI-Anschluss und/oder einen Klinkenanschluss oder auch andere Anschlüsse umfassen. Über die Anschlusskammer können hierbei eine oder mehrere elektrische Leitungen an (zweite) Anschlüsse an einer entlang der Querrichtung erstreckten Kante der Platine angeschlossen werden.

Die Elektronikbaugruppe mit ihrer Platine ist in die Aufnahmekammer des Gehäuses einzusetzen und ist, bei montiertem Gehäuse, in der Aufnahmekammer derart eingefasst, dass die Platine lagefest in der Aufnahmekammer gehalten ist. Um hierbei eine feste, definierte Lage der Platine innerhalb der Aufnahmekammer vorzugeben, kann die Platine mit einer oder mit mehreren Traversen verbunden sein, die beispielsweise entlang der Querrichtung an der Platine erstreckt sind und jeweils ein oder mehrere Formschlusselemente aufweisen, über die die Platine formschlüssig relativ zu dem Gehäuse festgelegt werden kann.

Die Traversen können beispielsweise an Befestigungsstellen mit der Platine verbunden sein, beispielsweise indem die Traversen an die Platine formschlüssig angeclipst sind. An Enden der Traverse können hierbei die Formschlusselemente ausgebildet sein, die beispielsweise in Formschlussöffnungen an den Seitenwandungen des Gehäuseoberteils eingreifen und dadurch die Platine formschlüssig innerhalb der Aufnahmekammer festlegen. Die Formschlussöffnungen an den Seitenwandungen können beispielsweise durch Aussparungen an unteren Kanten der Seitenwandungen gebildet sein, wobei durch Ansetzen des Gehäuseunterteils an das Gehäuseoberteil die Traversen zwischen dem Gehäuseoberteil und dem Gehäuseunterteil verklemmt werden, sodass auf diese Weise die Traversen und darüber die Platine formschlüssig innerhalb des Gehäuses festgelegt sind.

Das Gehäuse ist vorzugsweise mit Elektronikbaugruppen unterschiedlicher Größe bestückbar. Um hierbei das Gehäuse an unterschiedliche Bauformen unterschiedlicher Elektronikbaugruppen anzupassen, können ein oder mehrere unterschiedliche Adapterteile vorgesehen sein, die dazu dienen, einen Übergang zwischen einer Öffnung in einer Seitenwandung des Gehäuseoberteils und einem zugeordneten Anschluss der Elektronikbaugruppe herzustellen.

Ein solches Adapterteil kann beispielsweise eine Kastenform aufweisen und kann an eine Öffnung einer Seitenwandung angesetzt werden. Das Adapterteil weist einen nach außen hin offenen Gehäuseabschnitt auf, der an seinem Boden eine gegenüber der Öffnung der Seitenwandung zurückversetzte Adapteröffnung aufweist, über die eine elektrische Leitung mit einem Anschluss der Elektronikbaugruppe verbunden werden kann. Das Adapterteil erstreckt sich somit zwischen der Öffnung der Seitenwandung und dem zugeordneten Anschluss der Elektronikbaugruppe, sodass eine elektrische Leitung in das Adapterteil eingesetzt und über das Adapterteil elektrisch mit dem zugeordneten Anschluss der Elektronikbaugruppe verbunden werden kann.

In einer weiteren Ausführungsform können innerhalb der Aufnahmekammer auch mehrere Platinen aufgenommen sein. So kann beispielsweise innerhalb der Aufnahmekammer eine zweite Platine mit elektronischen Komponenten angeordnet sein, wobei diese zweite Platine beispielsweise entlang der Vertikalrichtung senkrecht zu der Platine der Elektronikbaugruppe versetzt ist, sodass die zweite Platine und die erste Platine der Elektronikbaugruppe in zueinander vertikal versetzten Ebenen angeordnet sind.

Die zweite Platine kann beispielsweise Steckverbinder oder dergleichen aufweisen, über die die erste Platine der Elektronikbaugruppe elektrisch mit der zweiten Platine kontaktiert werden kann. Die zweite Platine kann hierbei innerhalb des Gehäuses vorinstalliert sein, sodass bei Ansetzen der Elektronikbaugruppe an das Gehäuseoberteil die Kontakte der Elektronikbaugruppe selbsttätig mit zugeordneten Kontakten der zweiten Platine in Verbindung gelangen und somit die Elektronikbaugruppe mit der zweiten Platine kontaktiert wird.

Der der Erfindung zugrunde liegende Gedanke soll nachfolgend anhand der in den Figuren dargestellten Ausführungsbeispiele näher erläutert werden. Es zeigen:
- Fig. 1: eine perspektivische Ansicht eines Ausführungsbeispiels eines Gehäuses mit einer daran angeordneten Elektronikbaugruppe;
- Fig. 2: eine andere perspektivische Ansicht des Gehäuses, ohne die darin angeordneten Elektronikbaugruppe;
- Fig. 3A: eine stirnseitige Ansicht des Gehäuses;
- Fig. 3B: eine Seitenansicht des Gehäuses;
- Fig. 3C: eine Draufsicht auf das Gehäuse;
- Fig. 4: eine Schnittansicht entlang der Linie I-I gemäß Fig. 3C, mit einer in dem Gehäuse angeordneten Elektronikbaugruppe;
- Fig. 5A: eine perspektivische Ansicht eines Gehäuseoberteils des Gehäuses;
- Fig. 5B: eine andere perspektivische Ansicht des Gehäuseoberteils, mit einer in einer Aufnahmekammer angeordneten zweiten Platine;
- Fig. 6A: eine Ansicht einer in dem Gehäuse aufzunehmenden Elektronikbaugruppe in Form eines Einplatinencomputers;
- Fig. 6B: die Elektronikbaugruppe gemäß Fig. 6A, von unten;
- Fig. 7: eine Ansicht einer mit einer Platine der Elektronikbaugruppe zu verbindenden Traverse zum formschlüssigen Anordnen der Elektronikbaugruppe innerhalb der Aufnahmekammer des Gehäuses;
- Fig. 8A: eine Ansicht eines anderen Ausführungsbeispiels einer Elektronikbaugruppe kleinerer Bauform, zusammen mit einem Adapterteil;
- Fig. 8B: eine andere perspektivische Ansicht der Elektronikbaugruppe gemäß Fig. 8A;
- Fig. 9A: eine gesonderte Ansicht des Adapterteils; und
- Fig. 9B: eine andere Ansicht des Adapterteils.

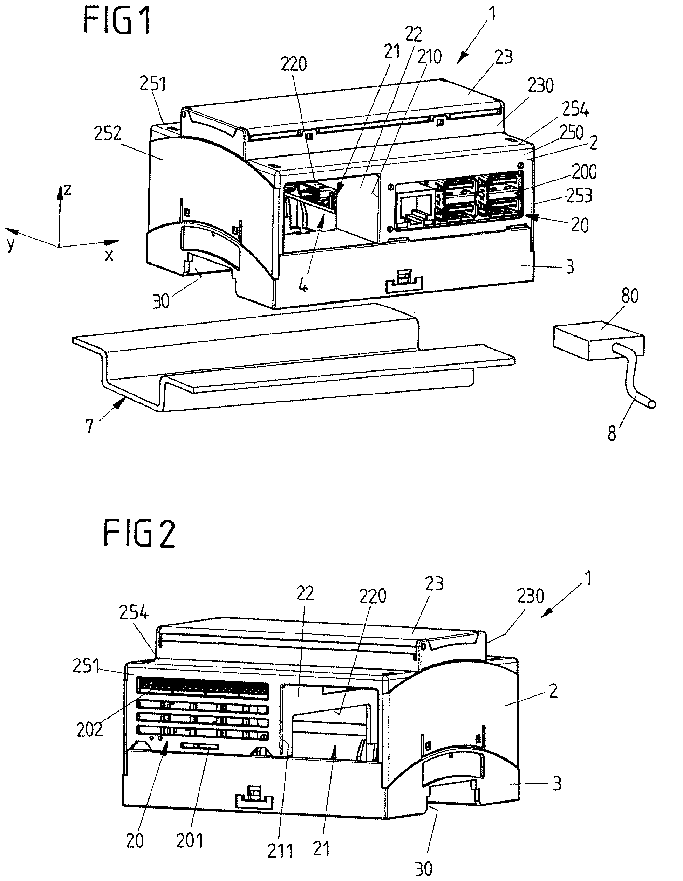

Fig. 1 und 2 zeigen ein Ausführungsbeispiel eines Gehäuses 1, das ein Gehäuseoberteil 2 und ein mit dem Gehäuseoberteil 2 zusammenfügbares Gehäuseunterteil 3 aufweist und über eine Befestigungseinrichtung 30 an einer Unterseite des Gehäuseunterteils 3 an eine Tragschiene 7 ansetzbar ist.

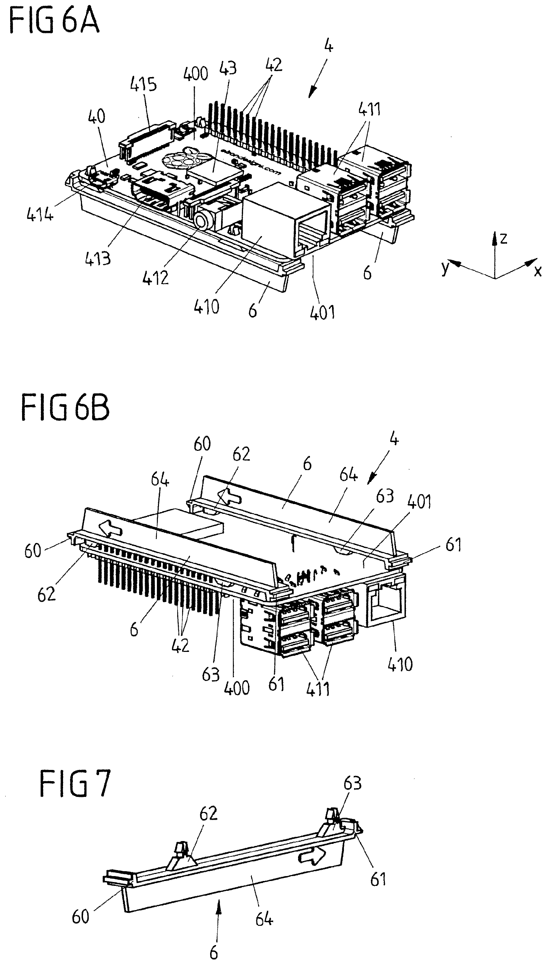

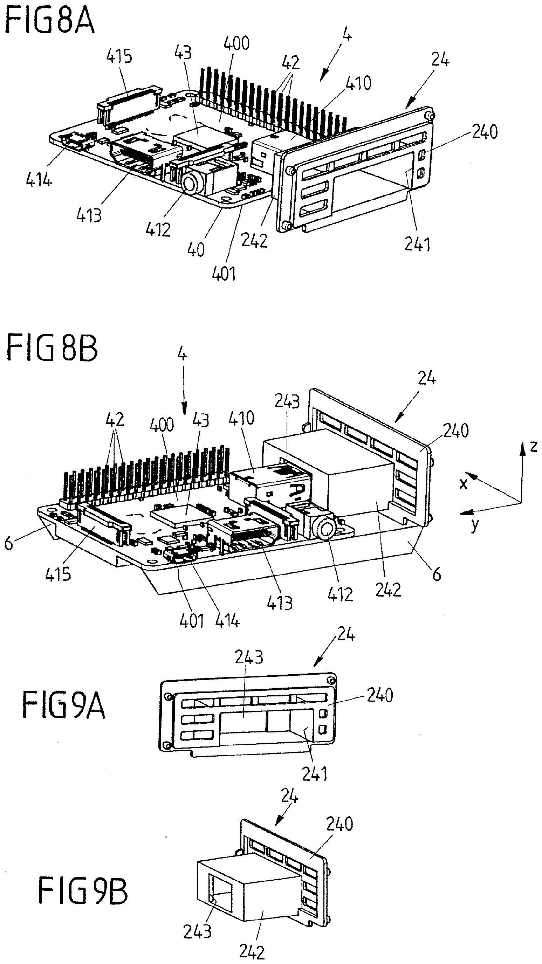

Das Gehäuse 1 dient zur Aufnahme einer Elektronikbaugruppe 4, die insbesondere als so genannter Einplatinencomputer ausgestaltet sein kann und - wie in unterschiedlichen Ausführungsbeispielen in Fig. 6A, 6B und 8A, 8B dargestellt-eine Platine 40 aufweist, die in einer Aufnahmekammer 20 innerhalb des Gehäuses 1 aufgenommen ist. Über das Gehäuse 1 kann diese Elektronikbaugruppe 4 an der Tragschiene 7 befestigt und mit anderen Elektronikgeräten kombiniert werden, indem das Gehäuse 1 mit anderen Elektronikgeräten entlang einer Längsrichtung X aneinandergereiht und an der Tragschiene 7 befestigt wird.

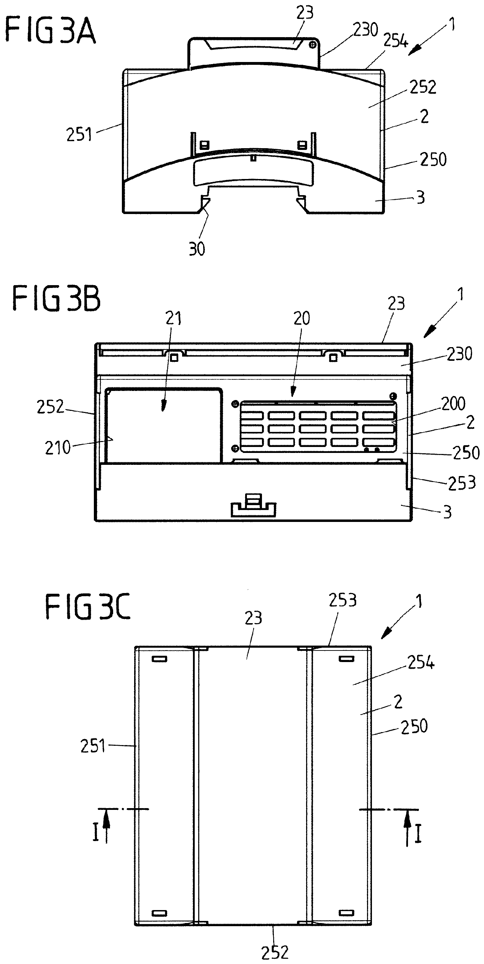

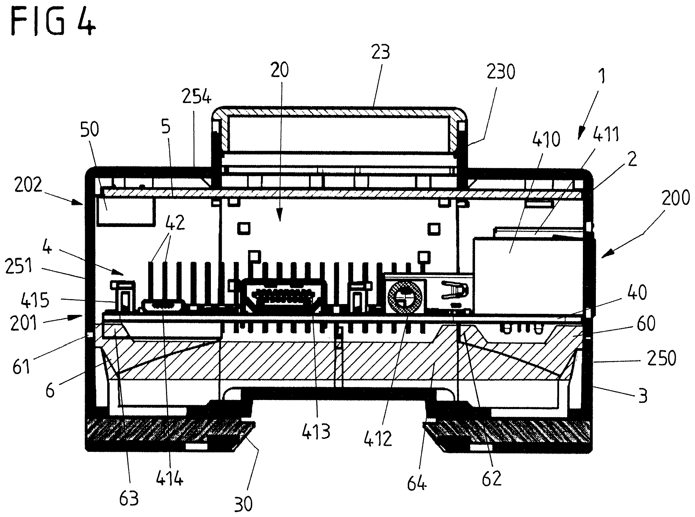

Fig. 3A bis 3C zeigen Ansichten des Gehäuses 1 von unterschiedlichen Seiten, und Fig. 4 zeigt eine Schnittansicht durch das Gehäuse 1 entlang der Schnittlinie I-I gemäß Fig. 3C.

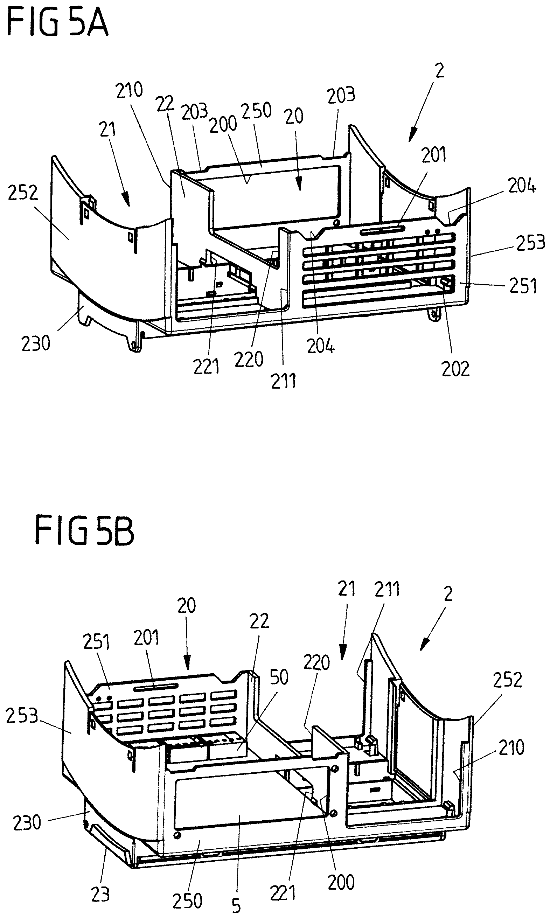

Fig. 5A, 5B zeigen gesonderte Ansichten des Gehäuseoberteils 2, das funktional zweigeteilt ist, indem es eine Aufnahmekammer 20 zur Aufnahme der Elektronikbaugruppe 4 und eine entlang der Längsrichtung X zu dieser Aufnahmekammer 20 versetzte Anschlusskammer 21, über die elektrische Leitungen an Anschlüsse 412, 413, 414 an einer entlang einer Querrichtung Y erstreckten Kante der Elektronikbaugruppe 4 (siehe Fig. 6A) angeschlossen werden können, aufweist.

Das Gehäuseoberteil 2 weist Seitenwandungen 250, 251 auf, zwischen denen die Aufnahmekammer 20 und die Anschlusskammer 21 gebildet sind. Die Seitenwandungen 250, 251 erstrecken sich in parallelen Ebenen, die durch die Längsrichtung X und eine Vertikalrichtung Z aufgespannt sind. Stirnseitig ist das Gehäuseoberteil 2 durch Stirnwandungen 252, 253 abgeschlossen, die Endflächen ausbilden, über die das Gehäuse 1 lückenlos an weitere Geräte angesetzt werden kann, um das Gehäuse 1 mit anderen Geräten an der Tragschiene 7 zu kombinieren. Oberseitig wird das Gehäuseoberteil 2 durch eine Deckenwandung 254 (siehe Fig. 1) abgeschlossen, an der über einen Kopfabschnitt 230 ein Deckel 23 angeordnet ist, der geöffnet werden kann, um einen Zugang zu dem Gehäuseinneren, also zu der Aufnahmekammer 20 und der Anschlusskammer 21, zu schaffen.

Wie aus den Ausführungsbeispielen der Elektronikbaugruppe 4 gemäß Fig. 6A und 6B bzw. 8A und 8B ersichtlich, weist die Elektronikbaugruppe 4 eine Mehrzahl von Anschlüssen 410-415 auf, die an unterschiedlichen Kanten der Platine 40 angeordnet und von unterschiedlichen Seiten der Elektronikbaugruppe 4 zugänglich sind. Die Anschlüsse 410-415 können beispielsweise einen Netzwerkanschluss (RJ45, Anschluss 410), USB-Anschlüsse (Anschlüsse 411), einen Klinkenanschluss (Anschluss 412), einen HDMI-Anschluss (Anschluss 413), einen Mini-USB-Anschluss (Anschluss 414) und einen Anschluss zum Einstecken einer Speicherkarte, zum Beispiel einer SD-Karte (Anschluss 415), bereitstellen. Zusätzlich können auch Anschlüsse vorgesehen sein, die auf einer Oberseite 400 der Platine 40 angeordnet und von oben zugänglich sind.

Zum Anschließen von elektrischen Leitungen 8 (siehe Fig. 1) an einen Anschluss 410-415 der Elektronikbaugruppe 4 ist erforderlich, einen Steckverbinder 80 der elektrischen Leitung 8 an die Seite der Elektronikbaugruppe 4 anzusetzen, an der der Anschluss 410-415 angeordnet ist. Hierzu sind in den Seitenwandungen 250, 251 Öffnungen 200, 201 ausgebildet, über die die Anschlüsse 410, 411, 415 an den entlang der Längsrichtung X erstreckten, seitlichen Kanten der Platine 40 zugänglich sind, wie dies aus den Ansichten des Gehäuses 1 gemäß Fig. 1 und 2 ersichtlich ist.
Zusätzlich ist ein Anschließen von elektrischen Leitungen 8 an die Anschlüsse 412, 413, 414 an der entlang der Querrichtung Y erstreckten Kante der Platine 40 über die Anschlusskammer 21 des Gehäuses 1 möglich. Die Anschlusskammer 21 ist hierzu über Öffnungen 210, 211 in den Seitenwandungen 250, 251 nach außen hin geöffnet, sodass elektrische Leitungen 8 über die Seitenwandungen 250, 251 in die Anschlusskammer 21 eingeführt werden können. Die Anschlusskammer 21 ist über eine Trennwand 22 von der Aufnahmekammer 20 getrennt, wobei in der Trennwand 22 eine Öffnung 220 in Form eines Durchbruchs vorgesehen ist, über die die Anschlüsse 412, 413, 414 an der quer erstreckten Kante der Platine 40 zugänglich sind, sodass innerhalb der Anschlusskammer 21 elektrische Leitungen 8 an die Anschlüsse 412, 413, 414 an der quer erstreckten Kante der Platine 40 angeschlossen werden können.

Dadurch, dass die Anschlusskammer 21 entlang der Längsrichtung X zu der Aufnahmekammer 20 versetzt ist, können somit elektrische Leitungen 8 hin zu der entlang der Querrichtung Y erstreckten Kante der Platine 40 der Elektronikbaugruppe 4 und den daran angeordneten Anschlüssen 412, 413, 414 verlegt werden, wobei die elektrischen Leitungen 8 über die Öffnungen 210, 211 in den Seitenwandungen 250, 251 aus dem Gehäuse 1 herausgeführt werden können, ohne dass die Leitungen 8 über die Stirnwandungen 252, 253 hinaus vorstehen. Das Gehäuse 1 kann somit ohne weiteres lückenlos mit anderen Geräten, beispielsweise anderen Elektronikgeräten oder zum Beispiel Reihenklemmen, kombiniert und an einer Tragschiene 7 befestigt werden.

Die Elektronikbaugruppe 4, wie sie in unterschiedlichen Ausführungsbeispielen in Fig. 6A, 6B und 8A, 8B dargestellt ist, kann beispielsweise einen Einplatinencomputer verwirklichen, bei dem auf einer Platine 40 ein oder mehrere Elektronikkomponenten 43 in Form von elektronischen Chips angeordnet sind. Die Elektronikbaugruppe 4 kann beispielsweise dazu ausgestaltet sein, Steuerungs- und Automatisierungsfunktionen in einer Industrieanlage zu übernehmen, und kann hierzu entsprechend programmierbar sein und ein geeignetes Betriebssystem aufweisen.

Die Elektronikbaugruppe 4 ist - in montiertem Zustand des Gehäuses 1 - vollständig innerhalb der Aufnahmekammer 20 des Gehäuses 1 eingefasst und dort gehalten. In einem Vormontagezustand liegt das Gehäuse 1 mit seinem Gehäuseoberteil 2 und seinem Gehäuseunterteil 3 getrennt vor, sodass die Elektronikbaugruppe 4 in die Aufnahmekammer 20 innerhalb des Gehäuseoberteils 2 eingesetzt werden kann.

An einer Unterseite 401 der Platine 40 sind zwei entlang der Querrichtung Y erstreckte Traversen 6 befestigt, die dazu dienen, die Elektronikbaugruppe 4 formschlüssig innerhalb der Aufnahmekammer 20 festzulegen. Wie aus der gesonderten Ansicht einer Traverse 6 in Fig. 7 ersichtlich ist, weist jede Traverse 6 einen entlang der Querrichtung Y erstreckten Steg 64 auf, der über Befestigungselemente 62, 63 in Form von Clipselementen an definierte Befestigungsstellen der Platine 40 angesetzt werden kann, um auf diese Weise die Traverse 6 mit der Platine 40 zu verbinden. An jedem Ende 60, 61 weist die Traverse 6 ein Formschlusselement auf, das dazu dient, einen Formschluss zwischen der Elektronikbaugruppe 4 und dem Gehäuse 1 herzustellen.

Wie aus den Ansichten des Gehäuseoberteils 2 gemäß Fig. 5A und 5B ersichtlich, sind an unterseitigen Kanten der Seitenwandungen 250, 251 Formschlussöffnungen 203, 204 in Form von Aussparungen ausgebildet, die dazu dienen, die Formschlusselemente an den Enden 60, 61 der Traversen 6 aufzunehmen. Wird die Elektronikbaugruppe 4 in die Aufnahmekammer 20 des Gehäuseoberteils 2 eingesetzt, so gelangen die Formschlusselemente an den einen Enden 60 der Traversen 6 in Eingriff mit den Formschlussöffnungen 203 an der Seitenwandung 250, während die Formschlusselemente an den gegenüberliegenden, anderen Enden 61 der Traverse 6 in Eingriff mit den Formschlussöffnungen 204 an der Seitenwandung 251 gelangen. Die Elektronikbaugruppe 4 nimmt somit eine definierte Lage innerhalb der Aufnahmekammer 20 relativ zu dem Gehäuseoberteil 2 ein, und durch Ansetzen des Gehäuseunterteils 3 an das Gehäuseoberteil 2 wird die Elektronikbaugruppe 4 über die Traverse 6 innerhalb der Aufnahmekammer 20 verklemmt, sodass die Elektronikbaugruppe 4 formschlüssig in der Aufnahmekammer 20 gehalten ist.

Die Verbindung des Gehäuseunterteils 3 mit dem Gehäuseoberteil 2 kann beispielsweise in formschlüssiger Weise erfolgen. Beispielsweise kann das Gehäuseunterteil 3 mit dem Gehäuseoberteil 2 verrastet werden, wobei diese Verbindung lösbar ausgestaltet sein kann, sodass beispielsweise unter Verwendung eines geeigneten Werkzeugs (wie eines Schraubendrehers) die Verrastung zwischen dem Gehäuseunterteil 3 und dem Gehäuseoberteil 2 gelöst werden kann, um das Gehäuse 1 zu demontieren.

Wie insbesondere aus Fig. 5B ersichtlich, kann innerhalb der Aufnahmekammer 20 des Gehäuseoberteils 2 eine weitere, zweite Platine 5 mit zusätzlichen elektronischen Komponenten aufgenommen sein. Die Platine 5 erstreckt sich entlang einer durch die Längsrichtung X und die Querrichtung Y aufgespannten Ebene und ist in Vertikalrichtung Z zu der Platine 40 der Elektronikbaugruppe 4 versetzt (wenn die Elektronikbaugruppe 4 in die Aufnahmekammer 20 eingesetzt ist).

An der weiteren Platine 5 können Anschlüsse 50 angeordnet sein, die über eine Öffnung 202 in der Seitenwandung 251 des Gehäuseoberteils 2 zugänglich sind. Andere Anschlüsse an einer Querkante der Platine 50 können über eine Öffnung 221 in der Trennwand 22 zwischen der Aufnahmekammer 20 und Anschlusskammer 21 zugänglich sein.

An der Platine 5 können geeignete Steckverbinder vorgesehen sein, die eine elektrische Kontaktierung zwischen der Platine 5 und Anschlüssen 42 an der Oberseite 400 der Platine 40 der Elektronikbaugruppe 4 herstellen, wenn die Elektronikbaugruppe 4 in die Aufnahmekammer 20 eingesetzt wird. Diese elektrische Kontaktierung kann selbsttätig erfolgen, wenn die Elektronikbaugruppe 4 in die Aufnahmekammer 20 eingesetzt wird. Die Elektronikbaugruppe 4 und Elektronikkomponenten der Platine 5 können somit elektrisch zusammenwirken, um z.B. Steuerungs- oder Automatisierungsfunktionen zu übernehmen.

Das Gehäuse 1 kann zur Aufnahme unterschiedlicher Elektronikbaugruppen 4 mit unterschiedlichen Abmessungen geeignet sein. So können, wie aus den unterschiedlichen Ausführungsbeispielen der Elektronikbaugruppen 4 gemäß Fig. 6A, 6B und 8A, 8B ersichtlich, die Platinen 40 der Elektronikbaugruppe 4 unterschiedliche Größen aufweisen. Dadurch, dass einheitliche Traversen 6 an die Unterseite 401 der jeweiligen Platine 40 angesetzt werden und die Platinen 40 hierzu definierte, einheitliche Befestigungsstellen zum Eingriff für die Befestigungselemente 62, 63 aufweisen, können die Elektronikbaugruppen 4 über die Traversen 6 in einheitlicher Weise innerhalb der Aufnahmekammer 20 aufgenommen und dort formschlüssig festgelegt werden.

Bei dem Ausführungsbeispiel gemäß Fig. 8A, 8B weist die Platine 40 der Elektronikbaugruppe 4 - im Vergleich zum Ausführungsbeispiel gemäß Fig. 6A, 6B - eine kleinere Länge entlang der Querrichtung Y auf. Wie schematisch in Fig. 8B angedeutet, überragen die Traversen 6 die Platine 40 in Querrichtung Y, sodass die Platine 40 über die Traversen 6 formschlüssig innerhalb der Aufnahmekammer 20 festgelegt werden kann.

Um hierbei ein Anschließen einer elektrischen Leitung 8 an einen Anschluss 410, der der Seitenwandung 250 des Gehäuseoberteils 2 zugeordnet und über die Öffnung 200 zugänglich ist, aber nunmehr aufgrund der kleineren Abmessungen der Platine 40 gegenüber der Öffnung 200 zurückversetzt ist, zu ermöglichen, ist ein Adapterteil 24 vorgesehen, dass an die Öffnung 200 angesetzt werden kann und die Öffnung 200 zumindest teilweise mit einer Blende 240 verdeckt. Das Adapterteil 24 weist einen in die Aufnahmekammer 20 hineinragenden Gehäuseabschnitt 242 auf, der nach außen hin über eine Öffnung 241 geöffnet ist und eine Kastenform aufweist. An einem Boden dieses Gehäuseabschnitts 242 ist eine Adapteröffnung 243 ausgebildet, in die der Anschluss 410 eingreift, sodass eine elektrische Leitung in den Gehäuseabschnitt 242 eingeführt und in den Anschluss 410 eingesteckt werden kann.

Für unterschiedliche Bauformen von Elektronikbaugruppen 4 können unterschiedliche Adapterteile 24 vorgesehen sein. Durch die Adapterteile 24 können insbesondere gegenüber den Seitenwandungen 250, 251 zurückversetzte Anschlüsse 410 der Elektronikbaugruppe 4 in einfacher Weise zugänglich gemacht werden, sodass ein Nutzer eine elektrische Leitung 8 unkompliziert an den Anschluss 410 ansetzen kann.

Durch Ansetzen des Gehäuses 1 an die Tragschiene 7 kann eine Elektronikbaugruppe 4 an der Tragschiene 7 befestigt werden. An der Tragschiene 7 kann hierbei ein Bussystem vorgesehen sein, dass durch Ansetzen des Gehäuses 1 beispielsweise mit einer geeigneten Anschlusseinrichtung an dem Gehäuseunterteil 3 des Gehäuses 1 kontaktieren kann, sodass über das Gehäuse 1 die Elektronikbaugruppe 4 auch mit dem Bussystem verbunden werden kann. Hierüber kann eine Kommunikationsverbindung zwischen der Elektronikbaugruppe 4 innerhalb des Gehäuses 1 und anderen Elektronikgeräten, die an der Tragschiene 7 angeordnet sind oder in sonstiger Weise mit dem Bussystem der Tragschiene 7 verbunden sind, hergestellt werden.

Die Erfindung ist nicht auf die vorangehenden Ausführungsbeispiele beschränkt, sondern ist durch die Ansprüche definiert.

So können innerhalb des Gehäuses grundsätzlich ganz unterschiedlich geartete Elektronikbaugruppen aufgenommen werden. Das Gehäuse ist insbesondere nicht auf die Aufnahme von Elektronikbaugruppen in Form von Einplatinencomputern beschränkt.

### Bezugszeichenliste

- 1: Gehäuse
- 2: Gehäuseoberteil
- 20: Aufnahmekammer
- 200-202: Öffnung
- 203, 204: Formschlussöffnung
- 21: Anschlusskammer
- 210, 211: Öffnung
- 22: Trennwand
- 220, 221: Öffnung
- 23: Deckel
- 230: Kopfbereich
- 24: Adapterteil
- 240: Blende
- 241: Öffnung
- 242: Gehäuseabschnitt
- 243: Adapteröffnung
- 250, 251: Seitenwandungen
- 252, 253: Stirnwandungen
- 254: Deckenwandung
- 3: Gehäuseunterteil
- 30: Befestigungseinrichtung
- 4: Elektronikgerät
- 40: Platine
- 400: Oberseite
- 401: Unterseite
- 410-415: Anschlüsse
- 42: Kontakte
- 43: Chip
- 5: Platine
- 50: Anschlüsse
- 6: Traverse
- 60, 61: Ende (Formschlusselement)
- 62, 63: Befestigungselement
- 64: Steg
- 7: Tragschiene
- 8: Elektrische Leitung
- 80: Anschluss
- X, Y, Z: Richtung

## Patentansprüche

1. Elektronikgerät (4) mit einem an einer Tragschiene (7) ansetzbaren Gehäuse (1), mit
- einem Gehäuseoberteil (2), das zwei längs entlang einer Längsrichtung (X) erstreckte, entlang einer Querrichtung (Y) quer zur Längsrichtung (X) zueinander beabstandete Seitenwandungen (250, 251) und eine zwischen den Seitenwandungen (250, 251) gebildete Aufnahmekammer (20) zur Aufnahme einer Elektronikbaugruppe (4) aufweist, wobei zumindest eine der Seitenwandungen (250, 251) eine erste Öffnung (200, 201) aufweist, über die eine erste elektrische Leitung (8) an einen ersten Anschluss (410, 411, 415) der Elektronikbaugruppe (4) anschließbar ist,
- wobei das Gehäuseoberteil (2) eine entlang der Längsrichtung (X) zu der Aufnahmekammer (20) versetzte, zwischen den Seitenwandungen (250, 251) gebildete Anschlusskammer (21) aufweist, die derart hin zu der Aufnahmekammer (20) geöffnet ist, dass über die Anschlusskammer (21) eine zweite elektrische Leitung (8) an einen zweiten elektrischen Anschluss (412-414) der Elektronikbaugruppe (4) anschließbar ist,
wobei
zumindest eine der Seitenwandungen (250, 251) eine zweite Offnung (210, 211) aufweist, über die die zweite elektrische Leitung (8) in die Anschlusskammer (21) einführbar ist,
wobei die Anschlusskammer (21) durch eine quer zur Längsrichtung (X) erstreckte Trennwand (22) von der Aufnahmekammer (20) getrennt ist, wobei die Trennwand (22) eine Öffnung (220) aufweist, über die die zweite elektrische Leitung (8) an den zweiten Anschluss (412-414) der Elektronikbaugruppe (4) anschließbar ist.
wobei das Gehäuseoberteil (20) zwei quer zur Längsrichtung (X) erstreckte Stirnwandungen (252, 253) aufweist, die entlang der Längsrichtung (X) zueinander beabstandet sind und Endflächen des Gehäuses (1) ausbilden, an die jeweils ein weiteres Gehäuse zum Anreihen mehrerer Gehäuse entlang der Längsrichtung (X) aneinander ansetzbar ist,
und mit einer in der Aufnahmekammer (20) des Gehäuses (1) aufgenommenen Elektronikbaugruppe (4)
wobei die Elektronikbaugruppe (4) eine Platine (40) mit einem darauf angeordneten elektronischen Bauteil (43) aufweist,
wobei der erste Anschluss (410, 411, 415) an einer entlang der Längsrichtung (X) erstreckten, ersten Kante der Platine (40) und der zweite Anschluss (412-414) an einer entlang der Querrichtung (Y) erstreckten, zweiten Kante der Platine (40) angeordnet ist.

2. Elektronikgerät (4) nach Anspruch 1, **gekennzeichnet durch** ein mit dem Gehäuseoberteil (2) zusammenfügbares Gehäuseunterteil (3), das eine Befestigungseinrichtung (30) aufweist, über die das Gehäuse (1) an einer entlang der Längsrichtung (X) längs erstreckten Tragschiene (7) befestigbar ist.

3. Elektronikgerät (4) nach Anspruch 2, **dadurch gekennzeichnet, dass** das Gehäuseunterteil (3) mit dem Gehäuseoberteil (2) formschlüssig verrastbar ist.

4. Elektronikgerät (4) nach einem der vorangehenden Ansprüche, **dadurch gekennzeichnet, dass** das Gehäuseoberteil (1) an einer die Seitenwandungen (250, 251) verbindenden Deckenwandung (254) einen Deckel (23) aufweist, der für einen Zugriff auf die Aufnahmekammer (20) und/oder die Anschlusskammer (21) zu öffnen ist.

5. Elektronikgerät (4) nach einem der vorangehenden Ansprüche, **dadurch gekennzeichnet, dass** die Elektronikbaugruppe (6) einen Einplatinencomputer verwirklicht.

6. Elektronikgerät (4) nach einem der vorangehenden Ansprüche, **dadurch gekennzeichnet, dass** an der Platine (40) zumindest eine Traverse (6) angeordnet ist, die zumindest ein Formschlusselement (60, 61) zum formschlüssigen Festlegen der Platine (40) an dem Gehäuse (1) aufweist.

7. Elektronikgerät (4) nach Anspruch 6, **dadurch gekennzeichnet, dass** die zumindest eine Traverse (6) entlang der Querrichtung (Y) an der Platine (40) erstreckt ist.

8. Elektronikgerät (4) nach Anspruch 6 oder 7, **dadurch gekennzeichnet, dass** das Gehäuseoberteil (2) an zumindest einer der Seitenwandungen (250, 251) eine Formschlussöffnung (203, 204) zum Aufnehmen des Formschlusselements (60, 61) der zumindest einen Traverse (6) aufweist.

9. Elektronikgerät (4) nach einem der vorangehenden Ansprüche, **dadurch gekennzeichnet, dass** die zumindest eine Traverse (6) bei montiertem Gehäuse (1) formschlüssig zwischen dem Gehäuseoberteil (2) und einem an das Gehäuseoberteil (2) angesetztem Gehäuseunterteil (3) gehalten ist.

10. Elektronikgerät (4) nach einem der vorangehenden Ansprüche, **gekennzeichnet durch** ein mit einer der Seitenwandungen (250, 251) verbundenes, an die erste Öffnung (200) anschließendes Adapterteil (24), das einen in die Aufnahmekammer (20) hineinragenden Gehäuseabschnitt (242) mit einer gegenüber der ersten Öffnung (200) zurückversetzten Adapteröffnung (243), über die die erste elektrische Leitung (8) mit dem ersten Anschluss (410) verbindbar ist, aufweist.

11. Elektronikgerät (4) nach einem der vorangehenden Ansprüche **dadurch gekennzeichnet, dass** innerhalb der Aufnahmekammer (20) eine zweite Platine (5) angeordnet ist, die entlang einer Vertikalrichtung (Z) senkrecht zur Längsrichtung (X) und senkrecht zur Querrichtung (Y) zu der Elektronikbaugruppe (4) versetzt ist.

12. Elektronikgerät (4) nach Anspruch 11, **dadurch gekennzeichnet, dass** die zweite Platine (5) elektrisch mit der Elektronikbaugruppe (4) kontaktiert ist.

## Claims

1. Electronic device (4) having a housing (1) which can be attached to a carrier rail (7), having
- a housing upper part (2) which has two side walls (250, 251) which extend longitudinally in a longitudinal direction (X) and are spaced apart from one another transversely with respect to the longitudinal direction (X) in a transverse direction (Y), and a receptacle chamber (20) which is formed between the side walls (250, 251) and has the purpose of receiving an electronic assembly (4), wherein at least one of the side walls (250, 251) has a first opening (200, 201) through which a first electrical line (8) can be connected to a first connection (410, 411, 415) of the electronic assembly (4),
- wherein the housing upper part (2) has a connecting chamber (21) which is offset with respect to the receptacle chamber (20) in the longitudinal direction (X) and is formed between the side walls (250, 251) and is opened towards the receptacle chamber (20) in such a way that a second electrical line (8) can be connected to a second electrical connection (412-414) of the electronic assembly (4) via the connecting chamber (21),
wherein at least one of the side walls (250, 251) has a second opening (210, 211) via which the second electrical line (8) can be inserted into the connecting chamber (21),
wherein the connecting chamber (21) is separated from the receptacle chamber (20) by a dividing wall (22) which extends transversely with respect to the longitudinal direction (X), wherein the dividing wall (22) has an opening (220) via which the electrical line (8) can be connected to the second connection (412-414) of the electronic assembly (4),
wherein the housing upper part (20) has two end walls (252, 253) which extend transversely with respect to the longitudinal direction (X), are spaced apart from one another in the longitudinal direction (X) and form end faces of the housing (1), to which a further housing can be respectively connected in order to connect a plurality of housings in a row in the longitudinal direction (X),
and having an electronic assembly (4) which is accommodated in the receptacle chamber (20) of the housing (1),
wherein the electronic assembly (4) has a circuit board (40) with an electronic component (43) arranged thereon,
wherein the first connection (410, 411, 415) is arranged on a first edge, which extends in the longitudinal direction (X), of the circuit board (40), and the second connection (412-414) is arranged on a second edge, which extends in the transverse direction (Y), of the circuit board (40) .

2. Electronic device (4) according to Claim 1, **characterized by** a housing lower part (3) which can be joined to the housing upper part (2) and has an attachment device (30) via which the housing (1) can be attached to a carrier rail (7) which extends longitudinally in the longitudinal direction (X).

3. Electronic device (4) according to Claim 2, **characterized in that** the housing lower part (3) can be latched in a positively locking fashion to the housing upper part (2).

4. Electronic device (4) according to one of the preceding claims, **characterized in that** the housing upper part (1) has, on a cover wall (254) which connects the side walls (250, 251), a lid (23) which can be opened for access to the receptacle chamber (20) and/or the connecting chamber (21).

5. Electronic device (4) according to one of the preceding claims, **characterized in that** the electronic assembly (6) implements a single-board computer.

6. Electronic device (4) according to one of the preceding claims, **characterized in that** at least one cross member (6) is arranged on the circuit board (40), said cross member (6) having at least one positively locking element (60, 61) for securing the circuit board (40) to the housing (1) in a positively locking fashion.

7. Electronic device (4) according to Claim 6, **characterized in that** the at least one cross member (6) extends in the transverse direction (Y) on the circuit board (40).

8. Electronic device (4) according to Claim 6 or 7, **characterized in that** the housing upper part (2) has, on at least one of the side walls (250, 251), a positively locking opening (203, 204) for receiving the positively locking element (60, 61) of the at least one cross member (6).

9. Electronic device (4) according to one of the preceding claims, **characterized in that** when the housing (1) is mounted the at least one cross member (6) is held in a positively locking fashion between the housing upper part (2) and a housing lower part (3) which is attached to the housing upper part (2).

10. Electronic device (4) according to one of the preceding claims, **characterized by** an adapter part (24) which is connected to the side walls (250, 251), connects to the first opening (200) and has a housing section (242) which projects into the receptacle chamber (20) and has an adapter opening (243) which is set back with respect to the first opening (200) and via which the first electrical line (8) can be connected to the first connection (410) .

11. Electronic device (4) according to one of the preceding claims, **characterized in that** a second circuit board (5) is arranged inside the receptacle chamber (20), said circuit board (5) being offset in a vertical direction (Z) perpendicularly to the longitudinal direction (X) and perpendicularly to the transverse direction (Y) with respect to the electronic assembly (4).

12. Electronic device (4) according to Claim 11, **characterized in that** the second circuit board (5) is placed in electrical contact with the electronic assembly (4).

## Revendications

1. Dispositif électronique (4) doté d'un boîtier (1) qui peut être fixé à un rail de montage (7), comprenant
- une partie supérieure de boîtier (2), qui présente deux parois latérales (250, 251) s'étendant longitudinalement le long d'une direction longitudinale (X) et espacées l'une de l'autre le long d'une direction transversale (Y) orientée transversalement à la direction longitudinale (X), et une chambre de réception (20) formée entre les parois latérales (250, 251) pour recevoir un module électronique (4), dans lequel au moins l'une des parois latérales (250, 251) présente une première ouverture (200, 201) par l'intermédiaire de laquelle une première ligne électrique (8) peut être raccordée à une première borne (410, 411, 415) du module électronique (4),
- dans lequel la partie supérieure de boîtier (2) présente une chambre de raccordement (21) décalée dans la direction longitudinale (X) par rapport à la chambre de réception (20) et formée entre les parois latérales (250, 251), qui est ouverte vers la chambre de réception (20) de manière à ce qu'une seconde ligne électrique (8) puisse être raccordée par l'intermédiaire de la chambre de raccordement (21) à une seconde borne électrique (412-414) du module électronique (4),
dans lequel au moins l'une des parois latérales (250, 251) présente une seconde ouverture (210, 211) par l'intermédiaire de laquelle la seconde ligne électrique (8) peut être introduite dans la chambre de raccordement (21),
dans lequel la chambre de raccordement (21) est séparée de la chambre de réception (20) par une paroi de séparation (22) s'étendant transversalement à la direction longitudinale (X), dans lequel la paroi de séparation (22) présente une ouverture (220) par l'intermédiaire de laquelle la seconde ligne électrique (8) peut être raccordée à la seconde borne (412-414) du module électronique (4),
dans lequel la partie supérieure de boîtier (20) présente deux parois frontales (252, 253) qui s'étendent transversalement à la direction longitudinale (X), sont espacées l'une de l'autre le long de la direction longitudinale (X) et forment des surfaces d'extrémité du boîtier (1), contre chacune desquelles un autre boîtier peut être placé afin d'agencer en rangée plusieurs boîtiers les uns à côté des autres le long de la direction longitudinale (X),
et comprenant un module électronique (4) reçu dans la chambre de réception (20) du boîtier (1),
dans lequel le module électronique (4) présente une carte (40) sur laquelle est disposé un composant électronique (43),
dans lequel la première borne (410, 411, 415) est disposée sur un premier bord de la carte (40) s'étendant dans la direction longitudinale (X) et la seconde borne (412-414) est disposée sur un second bord de la carte (40) s'étendant dans la direction transversale (Y).

2. Dispositif électronique (4) selon la revendication 1, **caractérisé par** une partie inférieure de boîtier (3) qui peut être assemblée à la partie supérieure de boîtier (2) et qui présente un dispositif de fixation (30) au moyen duquel le boîtier (1) peut être fixé à un rail de montage (7) s'étendant longitudinalement dans la direction longitudinale (X).

3. Dispositif électronique (4) selon la revendication 2, **caractérisé en ce que** la partie inférieure de boîtier (3) peut être enclenchée par complémentarité de forme avec la partie supérieure de boîtier (2).

4. Dispositif électronique (4) selon l'une des revendications précédentes, **caractérisé en ce que** la partie supérieure de boîtier (1) présente, sur une paroi de recouvrement (254) reliant les parois latérales (250, 251), un couvercle (23) qui peut être ouvert pour accéder à la chambre de réception (20) et/ou à la chambre de raccordement (21).

5. Dispositif électronique (4) selon l'une des revendications précédentes, **caractérisé en ce que** le module électronique (6) est réalisé sous la forme d'un ordinateur monocarte.

6. Dispositif électronique (4) selon l'une des revendications précédentes, **caractérisé en ce qu'**au moins une traverse (6) est disposée sur la carte (40) et présente au moins un élément à complémentarité de forme (60, 61) permettant de fixer par complémentarité de forme la carte (40) au boîtier (1).

7. Dispositif électronique (4) selon la revendication 6, **caractérisé en ce que** ladite au moins une traverse (6) s'étend le long de la direction transversale (Y) sur la carte (40).

8. Dispositif électronique (4) selon la revendication 6 ou 7, **caractérisé en ce que** la partie supérieure de boîtier (2) présente sur au moins l'une des parois latérales (250, 251) une ouverture à complémentarité de forme (203, 204) permettant de recevoir l'élément à complémentarité de forme (60, 61) de ladite au moins une traverse (6).

9. Dispositif électronique (4) selon l'une des revendications précédentes, **caractérisé en ce que** ladite au moins une traverse (6) est maintenue par complémentarité de forme lorsque le boîtier (1) est monté entre la partie supérieure de boîtier (2) et une partie inférieure de boîtier (3) montée sur la partie supérieure de boîtier (2).

10. Dispositif électronique (4) selon l'une des revendications précédentes, **caractérisé par** une partie adaptatrice (24) reliée à l'une des parois latérales (250, 251) et se raccordant à la première ouverture (200), qui présente une section de boîtier (242) faisant saillie à l'intérieur de la chambre de réception (20) et comprenant une ouverture adaptatrice (243) qui est en retrait par rapport à la première ouverture (200) et par l'intermédiaire de laquelle la première ligne électrique (8) peut être reliée à la première borne (410).

11. Dispositif électronique (4) selon l'une des revendications précédentes, **caractérisé en ce qu'**une seconde carte (5) qui est décalée le long d'une direction verticale (Z) perpendiculaire à la direction longitudinale (X) et perpendiculaire à la direction transversale (Y) du dispositif électronique (4) est disposée à l'intérieur de la chambre de réception (20).

12. Dispositif électronique (4) selon la revendication 11, **caractérisé en ce que** la seconde carte (5) est en contact électrique avec le module électronique (4).
